# EUROPÄISCHE PATENTSCHRIFT

(11) **EP 1 286 737 B1**
(45) Veröffentlichungstag und Bekanntmachung des Hinweises auf die Patenterteilung: **20.04.2005**
(21) Anmeldenummer: 01943419.0
(22) Anmeldetag: 21.05.2001
(51) Int. Cl.: B01D 9/00

(54) **VORRICHTUNG ZUR HERSTELLUNG VON KRISTALLEN**
DEVICE FOR PRODUCING CRYSTALS
DISPOSITIF POUR LA PRODUCTION DE CRISTAUX

(30) Priorität: 29.05.2000 DE 10026619
(43) Veröffentlichungstag der Anmeldung: 05.03.2003
(73) Patentinhaber: BASF AKTIENGESELLSCHAFT, 67056 Ludwigshafen (DE)
(72) Erfinder: ALLEN, Peter, Mark, 67435 Neustadt (DE); GAHN, Christoph, 67346 Speyer (DE); RIEKER, Christopher, William, 67112 Mutterstadt (DE); SCHNEIDER, Heinz-Walter, 67069 Ludwigshafen (DE); WAGNER, Robert, 67227 Frankenthal (DE)
(74) Vertreter: Isenbruck, Günter, Dr.
(86) Internationale Anmeldenummer: PCT/EP2001/005815
(87) Internationale Veröffentlichungsnummer: WO 2001/091874

(56) Entgegenhaltungen:
- WO-A-93/19826
- DE-A- 19 912 699
- US-A- 3 873 275
- PATENT ABSTRACTS OF JAPAN vol. 012, no. 496 (C-555), 23. Dezember 1988 (1988-12-23) & JP 63 209702 A (ISHIKAWAJIMA HARIMA HEAVY IND CO LTD), 31. August 1988 (1988-08-31)

## Beschreibung

Die Erfindung betrifft ein Verfahren zur Kristallisation von Stoffen.

Die Kristallisation von Stoffen aus Lösungen ist ein thermisches Trennverfahren. Eine Lösung mit molekulardisperser Verteilung eines oder mehrerer Feststoffe in einem Lösungsmittel wird durch ein meist mehrstufiges Eindampfen von Lösungsmittel vorkonzentriert. Die vorkonzentrierte Lösung muß dann übersättigt werden, damit sich Kristalle bilden und wachsen können. Beim Abbau dieser Übersättigung fällt der überschüssige Feststoff als mechanisch von der Restlösung abtrennbarer Bodenkörper aus. Aus der ursprünglichen Lösung wird also der gelöste Stoff abgetrennt. Wird eine bestimmte Korngrößenverteilung des Kristallisats gewünscht, so sind Übersättigungsgrad, Keimbildung und Kristallwachstum im dann entsprechend zu gestaltenden klassierenden Kristallisator durch Anpassung der Betriebsparameter wie Kühl- bzw. Abdampfgeschwindigkeit, Strömungsführung usw. zu kontrollieren.

Die treibende Kraft bei der Kristallisation ist der Unterschied der Konzentration des gelösten Stoffes in der übersättigten und der gerade gesättigten Lösung, d.h. die Störung des Lösungsgleichgewichts. Die vorkonzentrierte Lösung muß also zunächst gesättigt und dann über die Sättigung hinaus übersättigt werden. Die Übersättigung wird in der Praxis auf drei Arten erreicht:
- Bei großer Temperaturabhängigkeit der Löslichkeit wird die Übersättigung durch einfaches Abkühlen der gesättigten Lösung durch Oberflächenkühlung erreicht (Kühlungskristallisation);
- liegt nur eine geringfügige Temperaturabhängigkeit der Löslichkeit vor, so wird die Lösung durch Abdampfen von Lösungsmittel übersättigt (Verdampfungskristallisation);
- hängt die Löslichkeit merklich von der Temperatur ab oder ist die Lösung thermisch schonend zu behandeln, so werden Lösungskühlung und Lösungsmittelverdampfung kombiniert (Vakuumkristallisation).

In der Regel verläuft der Übersättigungsabbau in zwei simultan ablaufenden Schritten: Im ersten Schritt werden Kristallkeime gebildet, im zweiten Schritt wachsen jene Kristallkeime, die eine kritische Mindestgröße übertreffen, durch Aufnahme von Feststoff aus der übersättigten Lösung zu möglichst grobem Produktkristallisat an. Die Keimbildungsgeschwindigkeit wächst mit steigender Übersättigung; in der Regel ist nach Überschreiten einer bestimmten Übersättigung eine spontane Bildung vieler kleiner Keime zu beobachten. Dieser Effekt macht sich in der Bildung von sogenannten "Feinkristallschauern" bemerkbar. Zur notwendigen Kontrolle der Keimbildung im Kristallisator gilt es, insbesondere Feinanteile getrennt abzuziehen und entsprechend Feinkristallisat wieder aufzulösen. Die klassierende Kristallisatentnahme und Feinkornauflösung wird in "A. Mersmann, W.F. Beer und D. Seifert, Chem. Ing. Tech. 50 (1978) 2, 65-76, Verlag Chemie, Weinheim" beschrieben. Bei andauernder Übersättigung wachsen die in der Lösung vorgelegten Impfkristalle und/oder die gebildeten Keime zu größeren Kristallen heran. Dabei übersättigt sich die entsprechende Lösung wieder. Auf die Übersättigung der Lösung folgt als eigentliche Kristallisation der Übersättigungsabbau bis zum Wiedererreichen eines bestimmten Sättigungsgrades, bei dem die Bildung von "Feinkristallisatschauern" ausgelöst wird.

Ziel eines Kristallisationsvorganges ist in der Regel, ein kristallines, verkaufsfähiges Produkt einheitlicher Qualität herzustellen, wobei das Produkt diese Qualität insbesondere durch die Kristallgrößenverteilung erhält. Die Kristallgrößenverteilung hat Einfluß auf die Abtrennbarkeit der Restlösung, auf die Lagerfähigkeit der Kristalle, auf den Staubanteil, auf das Lösungsverhalten, auf die Streu- bzw. Rieselfähigkeit usw.. Die einheitliche Qualität des Produktes wird durch die zeitliche Fluktuation der Korngrößenverteilung der Kristalle beeinträchtigt - diese Fluktuation ist bedingt durch die periodisch anfallenden "Feinkristallschauer". Diese Feinkristallschauer verursachen letztendlich Produkt uneinheitlicher Qualität mit einem hohen feinkristallinen Anteil. Die feinkristallinen Anteile verursachen erhebliche Probleme bei der Aufarbeitung - feinkristalline Anteile lassen sich beispielsweise schlecht abzentrifugieren. Vorstehende Probleme treten auch bei den Kristallisatoren auf, die eine Feinkornauflösung aufweisen - auch bei solchen Kristallisatoren wird eine periodische Fluktuation der Korngrößenverteilung beobachtet.

Die Aufgabe der vorliegenden Erfindung ist, ein Verfahren bereitzustellen, mit der kontinuierlich Kristallisat erzeugt werden kann, das über die Zeit geringe Schwankungen der Korngrößenverteilung aufweist. Dabei soll insbesondere eine Reduzierung der Intensität der Feinsalzschauer erzielt werden. Das Verfahren soll die Durchführung eines effektiven und wirtschaftlichen Kristallisationsverfahrens gewährleisten.

Die Aufgabe wird gelöst durch ein Verfahren zur Kristallisation von Stoffen aus diese Stoffe enthaltenden Lösungen oder Dispersionen in einer ein inneres und äußeres Kreislaufsystem aufweisenden Vorrichtung, wobei
i) das innere Kreislaufsystem sich in einem eine Klassierzone enthaltenden Kristallisator befindet und dieser eine Kristalle der Stoffe aufweisende Dispersion aufweist, die durch das innere Kreislaufsystem bewegt wird,
ii) ein Teilstrom der Dispersion aus dem Kristallisator über die Klassierzone in das äußere Kreislaufsystem befördert wird,
iii) in dem äußeren Kreislaufsystem mittels eines Wärmetauschers die in dieser Dispersion enthaltende Kristalle aufgelöst werden,
iv) die Dispersion oder die durch vollständige Auflösung der Kristalle aus der Dispersion entstandene Lösung nachfolgend in das innere Kreislaufsystem des Kristallisators zurückgeführt wird,
v) eine die Stoffe enthaltende Lösung und/oder Dispersion dem Kristallisator und/oder dem äußeren Kreislaufsystem zugeführt wird und
vi) eine Kristalle der Stoffe aufweisende Dispersion dem äußeren Kreislaufsystem und/oder dem Kristallisator entnommen wird,
vii) dadurch gekennzeichnet, daß dem inneren Kreislaufsystem ein Teilstrom der Kristalle aufweisenden Dispersion entnommen und dieser Teilstrom über eine Leitung zur Rückführung der Dispersion dem äußeren Kreislaufsystem zugeführt wird, wobei die Leitung vor dem Wärmetauscher in das äußere Kreislaufsystem mündet, so dass die Auflösekapazität des Wärmetauschers durch die Zuführung dieses Teilstroms überfordert wird, wodurch die Kristalle der Dispersion nicht in einem wesentlichen Maße gelöst werden.

Die Erfindung kann durchgeführt werden auf Vorrichtung zur Kristallisation von Stoffen aus diese Stoffe enthaltenden Lösungen oder Dispersionen in einem eine Klassierzone enthaltenden Kristallisator aufweisend,
a) ein inneres und ein äußeres Kreislaufsystem, wobei das innere Kreislaufsystem sich in dem Kristallisator befindet, der Einlaß des äußeren Kreislaufsystems mit dem inneren Kreislaufsystem über die Klassierzone verbunden ist, das äußere Kreislaufsystem sich außerhalb des Kristallisators befindet, der Auslaß des äußeren Kreislaufsystems mit dem inneren Kreislaufsystem des Kristallisators verbunden ist und in dem äußeren Kreislaufsystem vor seinem Auslaß eine Einrichtung zur Auflösung von Kristallen angeordnet ist,
b) einen Zufluß für Lösung und/oder Dispersion, der sich an dem Kristallisator oder an dem äußeren Kreislaufsystem befindet,
c) einen Abfluß für Dispersionen, der an dem Kristallisator oder an dem äußeren Kreislaufsystem angeordnet ist und
d) zusätzlich eine das äußere und innere Kreislaufsystem miteinander verbindende Leitung zur Rückführung von Dispersion vorhanden ist.

Als Stoffe sollen chemische Verbindungen und Elemente verstanden werden, die kristallisierbar sind. Meist liegt in den diese Stoffe enthaltenen Lösungen oder Dispersionen nur jeweils ein Stoff vor - es werden somit nur Kristalle eines einzigen Stoffes erzeugt. Als Dispersionen sollen insbesondere Flüssigkeiten verstanden werden, die (feinverteilt) Kristalle enthalten. Häufig liegt die Dispersion als Suspension vor. Mit dem inneren Kreislaufsystem ist das durch den Kristallisator fließende Strömungssystem gemeint, das aus mehreren Teilströmen bestehen kann. Das innere Kreislaufsystem wird durch die Abmessungen - Form des Kristallisators - und durch die eine Bewegung verursachenden Einrichtungen, wie Pumpen oder Propeller, maßgeblich bestimmt. Das außerhalb des Kristallisators befindliche äußere Kreislaufsystem enthält bevorzugt entsprechende Verbindungsleitungen, bevorzugt Rohre, wobei in den Verbindungsleitungen eine Einrichtung zur Auflösung von Kristallen zwischengeschaltet ist. Die Klassierzone ist bevorzugt so in dem Kristallisator angeordnet, daß beim Betrieb des Kristallisators bevorzugt kleine Kristalle in die Klassierzone eingetragen werden. Die Leitungen der Vorrichtung sind meist als Rohre ausgebildet. Als Einrichtungen zur Auflösung von Kristallen eignen sich alle Einrichtungen, mit denen die Kristalle der Dispersionen gelöst werden können. In der Regel verursacht die Einrichtung zur Auflösung von Kristallen eine Temperaturänderung der Dispersion. Als Einrichtungen zur Auflösung von Kristallen sollen nur solche Einrichtungen verstanden werden, die ausgehend von dem in die Einrichtung eingeführten Dispersionsstrom, mindestens 5 Gew.%, bevorzugt mindestens 60 Gew.%, des in der Dispersion in Form von Kristallen vorliegenden Feststoffs auflösen.

Das erfindungsgemäße Verfahren ermöglicht eine Kristallisation, die sich durch eine enge Korngrößenverteilung der erzeugten Kristalle auszeichnet. Das Ausbleiben von "Feinkristallschauern" wird beim Betrieb zumindest weitgehend gewährleistet. Die erhaltenen Dispersionen lassen sich leichter aufarbeiten - die Zentrifugation der Kristalle gestaltet sich leichter und die bei der Aufarbeitung erhaltenen Kristallfraktionen weisen eine einheitliche Qualität auf.

Meist ist der Kristallisator als DTB-Kristallisator (draft-tube-baffled) oder als Fließbettkristallisator, bevorzugt als Oslo-Kristallisator, ausgebildet.

Meist liegt die Einrichtung zur Auflösung von Kristallen als Wärmetauscher oder gegebenenfalls als Reaktor zur Durchführung von exothermen Reaktionen vor. Dabei erfolgt die Auflösung der Kristalle entsprechend durch Erwärmen der Dispersion. Bevorzugt sind die Leitungen mit Pumpen zur Beförderung von Dispersion und Lösung ausgestattet. Ebenso weist in der Regel das äußere Kreislaufsystem Pumpen zur Beförderung der Dispersion bzw. der Lösung auf.

In einer bevorzugten Ausführungsform der Erfindung liegt die Klassierzone als Sedimentationszone vor. Die Kristalle werden dort aufgrund ihres unterschiedlichen Sedimentationsverhaltens klassiert, so daß bevorzugt kleinere Kristalle aus dem Kristallisator in das äußere Kreislaufsystem gelangen.

Das erfindungsgemäße Verfahren gewährleistet, daß der "Volumenstrom über die Feinkornauflösung" und die Klassierwirkung dieses Kreislaufes unabhängig voneinander eingestellt sind.

Die zeitlichen Schwankungen der Korngrößenverteilung (das "Schwingen bzw. das Fluktuieren" der Korngrößenverteilung), insbesondere verursacht durch die "Feinkornschauer", werden durch das erfindungsgemäße Verfahren signifikant verringert.

Das erfindungsgemäße Verfahren hat die Besonderheit, daß dem inneren Kreislaufsystem ein Teilstrom der Kristalle aufweisenden Dispersion entnommen und dem äußeren Kreislaufsystem zugeführt wird, ohne daß dabei jeweils die Kristalle der Dispersion in einem wesentlichen Maße gelöst werden.

Unter "in einem wesentlichen Maße gelöst werden" soll verstanden werden, daß mindestens 10 Gew.-%, bevorzugt 30 Gew.-% des in der Dispersion in Form von Kristallen vorliegenden Feststoffes gelöst werden.

Die Klassierung der Kristalle erfolgt bevorzugt aufgrund des unterschiedlichen Sedimentationsverhaltens der Kristalle.

In der Dispersion enthaltende Kristalle werden in der Regel durch Erwärmung der Dispersion gelöst. In einer bevorzugten Ausführungform der Erfindung sind die zu kristallisierenden Stoffe Ammoniumsulfat oder Adipinsäure. Als flüssige Komponente der Dispersion bzw. als Lösungsmittel für die Kristalle wird bevorzugt Wasser eingesetzt. Die Löslichkeit der Stoffe in der entsprechenden Flüssigkeit steigt in der Regel mit der Temperatur der Lösung bzw. Dispersion.

Meist wird die dem äußeren Kreislaufsystem und/oder dem Kristallisator entnommene, Kristalle der Stoffe aufweisende Dispersion aufgearbeitet und die Kristalle der Stoffe dabei in reiner Form gewonnen. Die dabei erhaltenen Kristallfraktionen weisen in der Regel einen geringen Feinkornanteil auf und besitzen eine enge Korngrößenverteilung. Diese Eigenschaften begünstigen eine einheitliche Qualität der Kristallfraktionen.

Die Erfindung betrifft außerdem eine Kristallfraktion, die, wie vorstehend erläutert, herstellbar ist.

Die anliegende Zeichnung zeigt:
- in Fig. 1 und 3 Schemata von Vorrichtungen zur Kristallisation von Stoffen nach Verfahren gemäß dem Stand der Technik - Fig. 1a und 3a zeigen ein Schema eines entsprechenden DTB-Kristallisators; Fig. 1b und 3b zeigen ein Schema eines entsprechenden Oslo-Kristallisators,
- in Fig. 2 Schemata von Vorrichtungen zur Kristallisation nach dem erfindungsgemäßen Verfahren (Fig. 2a zeigt den entsprechenden DTB-Kristallisator; Fig. 2b zeigt den entsprechenden Oslo-Kristallisator),
- in Fig. 4 ein Schema einer Vorrichtung zur Kristallisation nach dem erfindungsgemäßen Verfahren einschließlich der Anordnung von Einrichtungen zur Aufarbeitung der Dispersion und
- in Fig. 5 ein Diagramm, in der die mittlere Korngröße L in Abhängigkeit von der Zeit t aufgetragen ist; es liegen verschiedene Volumenströme für die (Rück)führung V_{b}/t und für das äußere Kreislaufsystems Vᵤ/t zugrunde.

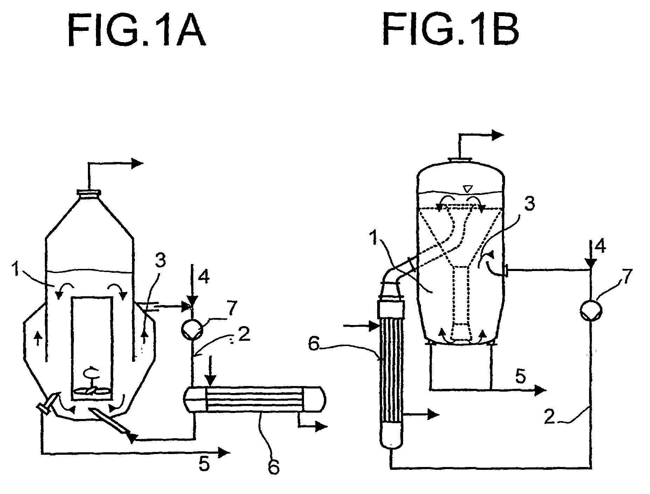

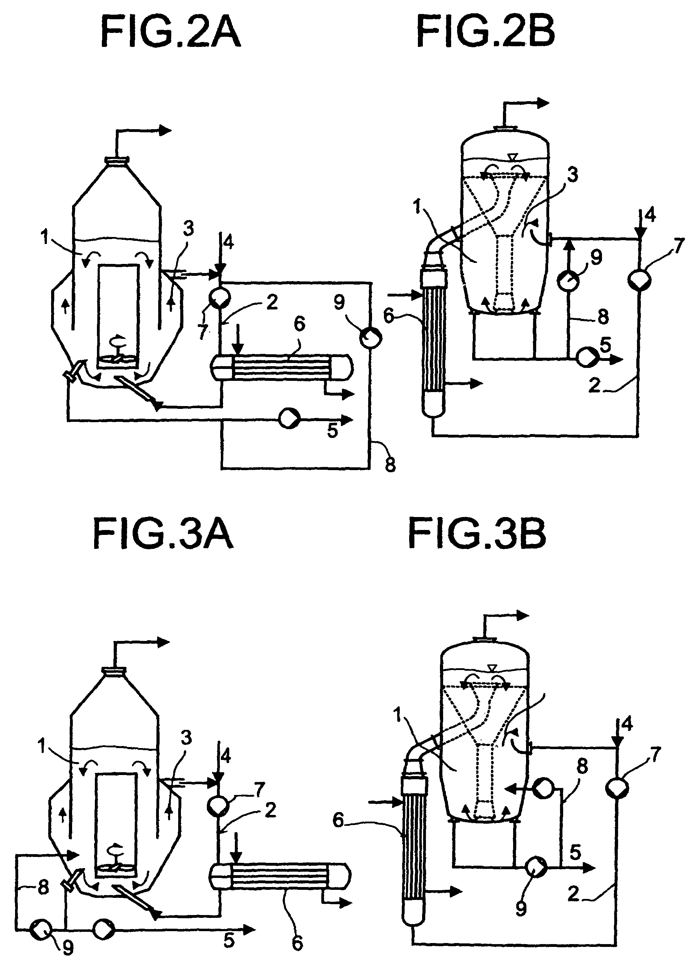

Die in den Figuren 1 bis 3 schematisch dargestellten Vorrichtungen zur Kristallisation weisen alle ein inneres Kreislaufsystem 1, ein äußeres Kreislaufsystem 2, eine Klassierzone 3, einen Zufluß 4, einen Abfluß 5, einen im äußeren Kreislaufsystem angeordneten Wärmetauscher 6 und eine zur Beförderung der Dispersion vorgesehene, im äußeren Kreislaufsystem angeordnete Pumpe 7 auf. Im Gegensatz zu den Vorrichtungen zur Durchführung von Verfahren nach dem Stand der Technik gemäß Fig. 1 weisen die Vorrichtungen zur Durchführung des erfindungsgemäßen Verfahrens gemäß Fig. 2 jedoch noch Leitungen 8 zur Rückführung der Dispersion auf. An diesen Leitungen 8 zur Rückführung sind jeweils Pumpen 9 zur Beförderung von Dispersion angeordnet.

Die Dispersion kann an jeder beliebigen Stelle des Kristallisators entnommen werden, bevorzugt jedoch im Bodenbereich. Die Dispersion, die in der Klassier zone 3 anfällt, kann über eine beliebige Anzahl von Stutzen in das äußere Kreislaufsystem 2 geführt werden. In der Regel sind dafür ein bis drei Stutzen vorgesehen.

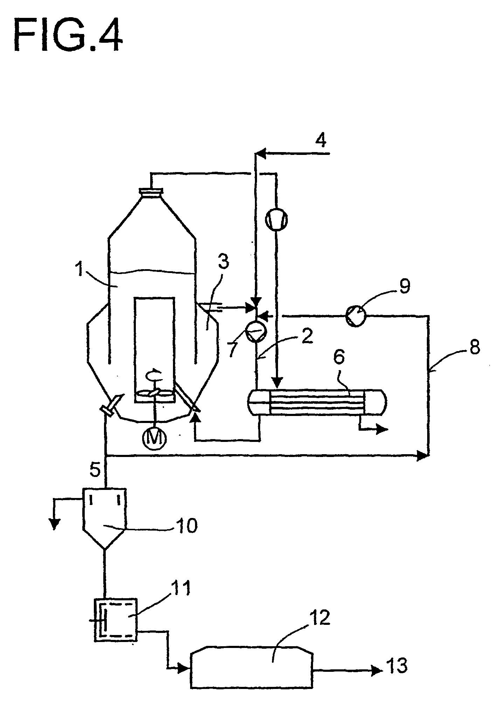

In Fig. 4 ist neben der Vorrichtung zur Kristallisation außerdem noch schematisch eine Anordnung zur Aufarbeitung der Dispersion aufgezeigt. Die Dispersion wird aus der Vorrichtung zur Kristallisation in einen Eindicker 10 geführt. In diesem sedimentieren die Kristalle und der Flüssigkeitsüberstand wird abgeführt. Die sich am Boden des Eindickers ansammelnden Kristalle werden in eine Zentrifuge 11 überführt und in dieser von weiterer Flüssigkeit befreit. Letztendlich erfolgt die Trocknung der aus der Zentrifuge herausgenommenen Kristalle in einem Trockner 12. Aus dem Trockner 12 wird die Kristallfraktionen 13 zur nachfolgenden Konfektionierung ausgeführt.

Wie vorstehend erläutert, zeigt Fig. 2 eine erfindungsgemäße Möglichkeit für die Rückführung der Dispersion auf. Alternativ zu der Anordnung in Fig. 2, in der die Leitung 8 für die Rückführung vor der Pumpe 7 in das äußere Kreislaufsystem 2 mündet, kann die Leitung 8 für die Rückführung auch zwischen der Pumpe 7 und dem Wärmetauscher 6 in das äußere Kreislaufsystem 2 münden. Hinsichtlich der in Fig. 3 schematisch gezeigten Anordnung, die eine weitere Vorrichtung zur Durchführung eines Verfahrens gemäß dem Stand der Technik darstellt, ist zu bemerken, daß die Rückführung der Dispersion einmal über die Leitung 8 und über eine Pumpe 9 erfolgen kann - die Rückführung kann jedoch auch über eine Pumpe und ein zusätzliches Zerkleinerungsorgan, wie eine Mühle, erfolgen.

Im folgenden soll die Erfindung anhand eines Beispiels zusätzlich näher erläutert werden.

### Beispiel

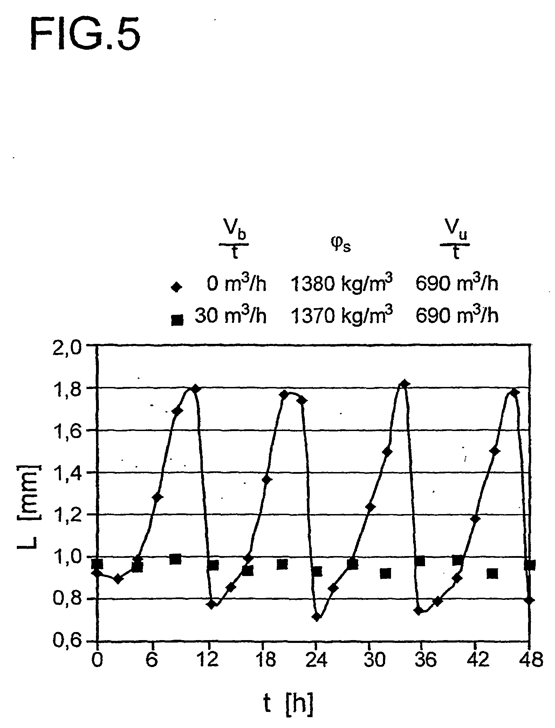

Zunächst wurde ein Vergleichsversuch nach dem Stand der Technik durchgeführt (Stoffsystem: Ammoniumsulfat/Wasser), wobei eine Anlage eingesetzt wurde, die schematisch in Fig. 1a aufgezeigt ist. Als Produkt des entsprechenden Verfahrens wurde ein Kristallisat mit einer periodisch fluktuierenden Korngrößenverteilung erhalten - die Korngrößenverteilung zeigt über die Zeit ein "schwingendes Verhalten" (siehe entsprechender Kurvenverlauf in Fig. 5). Als wesentlicher Grund für das "schwingende Verhalten" könnte eine zu effiziente Feinkomauflösung im Wärmetauscher angesehen werden. Das "schwingende Verhalten" könnte dann folgendermaßen erklärt werden:
- Zu einem Zeitpunkt "t" sei der Feinkornanteil im Kristallisator hoch. Dieses Feinkorn wird über die Klassierzone des Kristallisators in den Wärmetauscher gepumpt (für den Fall einer effizienten Feinkornauflösung dort vollständig aufgelöst);
- daraus resultiert eine Reduzierung des Feinkornanteils im Kristallisator und damit eine Reduzierung der Kristalloberfläche (damit ist die Summe der Oberflächen aller in der Suspension enthaltenen Kristalle gemeint), auf der die Übersättigung durch Kristallwachstum abgebaut wird. Eine Reduzierung der Kristalloberfläche hat deshalb ein Anstieg der Übersättigung zur Folge;
- die Übersättigung steigt bis zu einem kritischen Wert, bei dem kleine Abriebsfragmente (kleiner 50 µm) zum Wachstum aktiviert werden;
- durch das Wachstum dieser Fragmente steigt die Kristalloberfläche im Kristallisator wieder zügig an und die Übersättigung wird damit entsprechend schnell abgebaut. Die große Anzahl wachsender ("kleiner") Kristalle äußert sich als Feinkristallschauer;
- dieses Feinkorn wird nun mit der Zeit wieder im Wärmetauscher aufgelöst, und der Zyklus beginnt von neuem.

Um die zeitliche Fluktuation der Korngrößenverteilung zu verhindern, wurde erfindungsgemäß ein Versuch in einer Anlage durchgeführt, die schematisch in Fig. 2a aufgezeigt ist (Stoffsystem: Ammoniumsulfat/Wasser). Dabei wurde aus dem inneren Kreislaufsystem 1 über eine Leitung 8 für die Rückführung Dispersion in das äußere Kreislaufsystem 2 vor die Pumpe 7 befördert. Dadurch wurde in das äußere Kreislaufsystem zusätzliches Kristallisat, insbesondere auch Kristallisat von größerer Korngröße, in den Wärmetauscher 6 geführt. Die Auflösekapazität des Wärmetauschers wurde durch die Zuführung dieses. Kristallisats überfordert, wodurch eine effiziente Auflösung von Feinkorn in dem Wärmetauscher 8 verhindert wurde. Dabei lagen folgende Betriebsbedingungen vor:
- Volumenstrom Vₒ/ t über das äußere Kreislaufsystem 2 690 m³/h
- Zulauf (in die Vorrichtung) 50 m³/h
- Produktionsmenge (Kristalle, die mit der Anlage gemäß Fig. 4 aufgearbeitet worden sind; Sedimentieren, Zentrifugieren, Trocknen) 9 t/h.

In Fig. 5 ist das Ergebnis des Versuchs dargestellt. Es zeigt sich, daß bei einem hohen Volumenstrom V_{b}/t der Rückführung die zeitliche Fluktuation der Korngrößenverteilung weitestgehend verhindert werden kann. Im Gegensatz dazu führt der Verzicht auf eine Rückführung - Vergleichsversuch (V_{b}/t = 0) - zu einer starken Fluktuation der mittleren Korngröße L über die Zeit. Die erfindungsgemäße Rückführung von Dispersion gewährleistet somit eine einheitliche Qualität des Produktes sowie die Unterbindung der Feinkornschauer, was zu einer leichteren Aufarbeitung führt. Außerdem war es möglich, den Gehalt an Ammoniumsulfat im Zulauf so stark zu erhöhen, daß eine Produktionsmenge von 11 t/h erreicht wurde, ohne daß damit eine merklich Verschlechterung der Produktqualität einherging. Bei gleicher Erhöhung des Ammoniumsulfatgehalts im Zulauf würde bei dem vorstehend genannten Verfahren nach dem Stand der Technik eine starke Zunahme der Intensität der Feinkomschauer resultieren, so daß dann die Aufarbeitung in erheblichem Maße erschwert würde (Probleme u.a. beim Zentrifugieren und Trocknen). Das erfindungsgemäße Verfahren ermöglicht somit auch eine Steigerung der Produktionsmenge.

## Patentansprüche

1. Verfahren zur Kristallisation von Stoffen aus diese Stoffe enthaltenden Lösungen oder Dispersionen in einer ein inneres und äußeres Kreislaufsystem aufweisenden Vorrichtung, wobei
i) das innere Kreislaufsystem sich in einem eine Klassierzone enthaltenden Kristallisator befindet und dieser eine Kristalle der Stoffe aufweisende Dispersion aufweist, die durch das innere Kreislaufsystem bewegt wird,
ii) ein Teilstrom der Dispersion aus dem Kristallisator über die Klassierzone in das äußere Kreislaufsystem befördert wird,
iii) in dem äußeren Kreislaufsystem mittels eines Wärmetauschers die in dieser Dispersion enthaltende Kristalle aufgelöst werden,
iv) die Dispersion oder die durch vollständige Auflösung der Kristalle aus der Dispersion entstandene Lösung nachfolgend in das innere Kreislaufsystem des Kristallisators zurückgeführt wird,
v) eine die Stoffe enthaltende Lösung und/oder Dispersion dem Kristallisator und/oder dem äußeren Kreislaufsystem zugeführt wird und
vi) eine Kristalle der Stoffe aufweisende Dispersion dem äußeren Kreislaufsystem und/oder dem Kristallisator entnommen wird,
vü) **dadurch gekennzeichnet, daß** dem inneren Kreislaufsystem ein Teilstrom der Kristalle aufweisenden Dispersion entnommen und dieser Teilstrom über eine Leitung zur Rückführung der Dispersion dem äußeren Kreislaufsystem zugeführt wird, wobei die Leitung vor dem Wärmetauscher in das äußere Kreislaufsystem mündet, so dass die Auflösekapazität des Wärmetauschers durch die Zuführung dieses Teilstroms überfordert wird, wodurch die Kristalle der Dispersion nicht in einem wesentlichen Maße gelöst werden.

2. Verfahren nach Anspruch 1, **dadurch gekennzeichnet, dass** die Leitung zur Rückführung der Dispersion vor dem Wärmetauscher und der zur Beförderung der Dispersion vorgesehenen, im äußeren Kreislaufsystem angeordneten Pumpe in das äußere Kreislaufsystem mündet.

3. Verfahren nach Anspruch 1 oder 2, **dadurch gekennzeichnet, dass** mindestens 10 Gew.-%, bevorzugt 30 Gew.-%, der Kristalle der Dispersion nicht gelöst werden.

4. Verfahren nach einem der Ansprüche 1 bis 3, **dadurch gekennzeichnet, daß** als Kristallisator ein DTB-Kristallisator oder ein Fließbettkristallisator, bevorzugt ein Oslo-Kristallisator, verwendet wird.

5. Verfahren nach einem der Ansprüche 1 bis 4, **dadurch gekennzeichnet, daß** in der Dispersion enthaltene Kristalle durch Erwärmung der Dispersion gelöst werden.

6. Verfahren nach einem der Ansprüche 1 bis 5, **dadurch gekennzeichnet, daß** die zu kristallisierenden Stoffe Ammoniumsulfat oder Adipinsäure sind.

7. Verfahren nach einem der Ansprüche 1 bis 6, **dadurch gekennzeichnet, daß** die dem äußeren Kreislaufsystem und/oder dem Kristallisator entnommene, Kristalle der Stoffe aufweisende Dispersion, aufgearbeitet wird und die Kristalle der Stoffe dabei in reiner Form gewonnen werden.

## Claims

1. A process for crystallizing substances from solutions or dispersions comprising these substances, in an apparatus having an inner and an outer circulation system,
i) the inner circulation system being present in a crystallizer comprising a classifying zone and said crystallizer containing a dispersion which comprises crystals of the substances and is moved through the inner circulation system,
ii) a part-stream of the dispersion being transported from the crystallizer via the classifying zone into the outer circulation system,
iii) crystals comprised in this dispersion being dissolved in the outer circulation system by means of a heat exchanger,
iv) the dispersion or the solution formed by complete dissolution of crystals from the dispersion being subsequently recycled to the inner circulation system of the crystallizer,
v) a solution and/or dispersion comprising the substances being fed to the crystallizer and/or to the outer circulation system and
vi) a dispersion comprising crystals of the substances being removed from the outer circulation system and/or from the crystallizer,
vii) wherein a part-stream of the dispersion comprising crystals is removed from the inner circulation system and is fed to the outer circulation system via a line for recycling the dispersion, the line entering the outer circulation system before the heat exchanger, so that the dissolution capacity of the heat exchanger is overstretched by feeding in this part-stream, without the crystals of the dispersion being dissolved to a substituted extent.

2. A process as claimed in claim 1, wherein the line for recycling the dispersion enters the outer circulation system beforee the heat exchanger and the pump for transporting dispersion which is arranged in the outer circulation system.

3. A process as claimed in claim 1 or 2, wherein at least 10%, preferably 30%, by weight of the crystals in the dispersion are not dissolved.

4. A process as claimed in any of claims 1 to 3, wherein the crystallizer is in the form of a DTB crystallizer or in the form of a fluidized-bed crystallizer, preferably in the form of an Oslo crystallizer.

5. A process as claimed in any of claims 1 to 4, wherein crystals comprised in the dispersion are dissolved by heating the dispersion.

6. A process as claimed in any of claims 1 to 5, wherein the substances to be crystallized are ammonium sulfate or adipic acid.

7. A process as claimed in any of claims 1 to 6, wherein the dispersion removed from the outer circulation system and/or from the crystallizer and comprising crystals of the substances is worked up and the crystals of the substances are thus obtained in pure form.

## Revendications

1. Procédé de cristallisation de substances à partir de solutions ou de dispersions qui contiennent ces substances, dans un dispositif qui présente un système interne de recirculation et un système externe de recirculation, dans lequel:
i) le système interne de recirculation est situé dans un cristalliseur qui contient une zone de classification et une dispersion qui présente des cristaux des substances et qui est déplacée dans le système interne de recirculation,
ii) un écoulement partiel de la dispersion est amené du cristalliseur au système externe de recirculation en passant par la zone de classification,
iii) les cristaux contenus dans cette dispersion sont dissous dans le système externe de recirculation au moyen d'un échangeur de chaleur,
iv) la dispersion ou la solution obtenue à partir de la dispersion par dissolution complète des cristaux est ensuite ramenée dans le système interne de recirculation du cristalliseur,
v) une solution et/ou une dispersion qui contiennent les substances sont amenées au cristalliseur et/ou au système externe de recirculation et
vi) une dispersion qui présente des cristaux des substances est extraite du système externe de recirculation et/ou du cristalliseur,
vii) **caractérisé en ce qu'**un écoulement partiel de la dispersion qui présente les cristaux est extrait du système interne de recirculation et est amené au système externe de recirculation par l'intermédiaire d'un conduit de renvoi de la dispersion qui débouche dans le système externe de recirculation en amont de l'échangeur de chaleur, de telle manière que l'écoulement partiel amené sollicite à l'excès la capacité de dissolution de l'échangeur de chaleur, grâce à quoi les cristaux de la dispersion ne sont pas dissous dans une mesure significative.

2. Procédé selon la revendication 1, **caractérisé en ce que** le conduit de renvoi de la dispersion débouche dans le système externe de recirculation en amont de l'échangeur de chaleur et de la pompe qui est prévue pour faire avancer la dispersion et qui est agencée dans le système externe de recirculation.

3. Procédé selon les revendications 1 ou 2, **caractérisé en ce qu'**au moins 10 % en poids et de préférence 30 % en poids des cristaux de la dispersion ne sont pas dissous.

4. Procédé selon l'une des revendications 1 à 3, **caractérisé en ce que**, comme cristalliseur, on utilise un cristalliseur dit DTB ou un cristalliseur à lit fluidisé et de préférence un cristalliseur dit Oslo.

5. Procédé selon l'une des revendications 1 à 4, **caractérisé en ce que** des cristaux contenus dans la dispersion sont dissous en chauffant celle-ci.

6. Procédé selon l'une des revendications 1 à 5, **caractérisé en ce que** les substances à cristalliser sont du sulfate d'ammonium ou de l'acide adipique.

7. Procédé selon l'une des revendications 1 à 6, **caractérisé en ce que** la dispersion qui présente des cristaux des substances et qui est retirée du système externe de recirculation et/ou du cristalliseur est retraitée pour obtenir les cristaux des substances à l'état pur.
